# EUROPÄISCHE PATENTSCHRIFT

(11) **EP 3 653 578 B1**
(45) Veröffentlichungstag und Bekanntmachung des Hinweises auf die Patenterteilung: **21.04.2021**
(21) Anmeldenummer: 18206150.7
(22) Anmeldetag: 14.11.2018
(51) Int. Cl.: C01B 33/107, C23C 16/00

(54) **TETRAKIS(TRICHLORSILYL) GERMAN, VERFAHREN ZU DESSEN HERSTELLUNG**
TETRAKIS(TRICHLORSILYL) GERMAN, METHOD FOR PRODUCING SAME
TÉTRAKIS-(TRICHLOROSILYLE)-GERMANE, SON PROCÉDÉ DE PRODUCTION

(43) Veröffentlichungstag der Anmeldung: 20.05.2020
(73) Patentinhaber: Evonik Operations GmbH, 45128 Essen (DE)
(72) Erfinder: WAGNER, Matthias, 61194 Niddatal (DE); TEICHMANN, Julian, 60327 Frankfurt am Main (DE); LERNER, Hans-Wolfram, 61440 Oberursel (DE)
(74) Vertreter: Evonik Patent Association

(56) Entgegenhaltungen:
- WO-A2-2004/036631
- MULLER L ET AL: "Trichlorosilylation of chlorogermanes and chlorostannanes with HSiCl3/Net3 followed by base-catalysed formation of (Me3Ge)2Si(SiCl3)2 and related branched stannylsilanes", JOURNAL OF ORGANOMETALLIC CHEMISTRY, ELSEVIER, AMSTERDAM, NL, Bd. 579, Nr. 1-2, 5. Mai 1999 (1999-05-05) , Seiten 156-163, XP004170561, ISSN: 0022-328X, DOI: 10.1016/S0022-328X(98)01218-2
- JOINER ET AL: "Systematic preparation of chloropolysilanes and chlorosilylgermanes", DISSERTATION, (MEDFORD, TUFTS UNIV., PH. D. THESIS, 1973, (GB, 1. Januar 1973 (1973-01-01), Seiten 1-68, XP009501947,
- JULIAN TEICHMANN ET AL: "Tris(trichlorosilyl)tetrelide Anions and a Comparative Study of Their Donor Qualities", CHEMISTRY - A EUROPEAN JOURNAL, Bd. 25, Nr. 11, 21. Dezember 2018 (2018-12-21), Seiten 2740-2744, XP055580991, DE ISSN: 0947-6539, DOI: 10.1002/chem.201806298

## Beschreibung

Die vorliegende Erfindung betrifft das neue Verfahren zur Herstellung der chlorierten, ungeladenen Sustanz Tetrakis(trichlorsilyl)german, sowie deren Verwendung.

Halogensilane, Polyhalogensilane, Halogengermane, Polyhalogengermane, Silan, Polysilane, German, Polygermane sowie entsprechende Mischverbindungen sind lange bekannt, vgl. neben den gängigen Lehrbüchern der anorganischen Chemie auch WO 2004/036631 A2 oder C.J. Ritter et al., J. Am. Chem. Soc., 2005, 127, 9855-9864.

Lars Müller et al. beschreiben im J. Organomet. Chem. 1999, 579, 156 - 163, eine Methode zur Herstellung von Si-Ge Bindungen durch Umsetzung von teilchlorierten organischen Germaniumverbindungen mit Trichlorsilan unter Zugabe von Triethylamin.

Eine weitere Möglichkeit, neutrale Si-Ge Verbindungen zu erzeugen, stellen Thomas Lobreyer et al. anhand der Umsetzung von SiH₄ und GeH₄ mit Natrium vor (Angew. Chem. 1993, 105, 587 - 588).

Singh et al. schlagen in WO 2004/036631 A2 verschiedene Si-Ge Verbindungen für die Abscheidung von Si- bzw. Si aufweisenden Filmen vor.

Die Patentanmeldungen EP 17173940.2, EP 17173951.9 und EP 17173959.2 offenbaren weitere Si-Ge Verbindungen und Verfahren zu deren Herstellung.

So ist man seitens der Grundlagenforschung bestrebt, neue Verbindungen oder zumindest neue Herstellungswege für solche Verbindungen zu finden, insbesondere auch mit Hinblick auf mögliche industrielle sowie ggf. verbesserbare Anwendungen.

Der vorliegenden Erfindung lag die Aufgabe zugrunde, eine neue Synthesemöglichkeit zur Herstellung einer ungeladenen Silicium-Germanium Verbindung ohne den Einsatz pyrophorer oder giftiger Substanzen bereit zu stellen.

Eine völlig neue Synthesemöglichkeit wurde mit der Umsetzung von Ammonium- bzw. Phosphoniumtris(trichlorosilyl)germanid-Salzen des Typs [R₄N][Ge(SiCl₃)₃] bzw. [R₄P][Ge(SiCl₃)₃] mit AlCl₃ und alkylischen oder aromatischen Resten R gefunden, die zu einer ungeladenen, chlorierten Si-Ge Verbindung führt. Das Überraschende an dieser neuen Synthese ist unter Anderem, dass das resultierende Tetrakis(trichlorsilyl)german in einem Schritt erzeugt wird und *ungeladen* ist.

Gegenstand der Erfindung ist demnach das Verfahren Verfahren zur Herstellung von Tetrakis(trichlorsilyl)german der Formel (I), 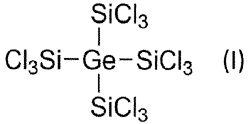 indem man
(a) zumindest ein Tris(trichlorosilyl)germanidsalz des Typs [X][Ge(SiCl₃)₃] mit X = Ammonium (R₄N) und/oder Phosphonium (R₄P), R = alkylischer oder aromatischer Rest, mit AlCl₃ mischt, und
(b) in Umgebung zumindest eines Chlorkohlenwasserstoffes bei einer Temperatur von 5 bis 40 °C umsetzt, wobei man ein Rohprodukt erhält, das Salze [R₄N][AlCl₄] und/oder [R₄P][AlCl₄], und Tetrakis(trichlorsilyl)german enthält, und anschließend dieses Rohprodukt
(c) in zumindest ein unpolares Lösungsmittel einbringt und den unlöslichen Rückstand abtrennt, und anschließend
(d) das unpolare Lösungsmittel entfernt, wobei Tetrakis(trichlorsilyl)german erhalten wird.

Das Verfahren hat den Vorteil, dass weder pyrophore, noch giftige Substanzen wie z.B. SiH₄, GeH₄ oder Natrium eingesetzt werden müssen. Zwar sind im Stand der Technik bereits Verfahren bekannt, die den Einsatz solch gefährlicher Substanzen umgehen. Doch diese konventionellen Verfahren bringen in der Regel neutrale Si-Ge-Verbindungen mit organischen Resten hervor. Organische Reste verhindern den Einsatz der Si-Ge-Verbindungen in solchen Abscheidungsreaktionen, die für die Halbleiterelektronik interessant sind, weil bei den während der Abscheidung eingestellten Temperaturen SiC gebildet wird. SiC ist nichtleitend und zerstört die gewünschte leitende oder halbleitende Eigenschaft von Si-Ge-Schichten.

Ebenso wenig können salzartige Si-Ge-Verbindungen in der Halbleiterelektronik eingesetzt werden, da in solchen Substanzen organische Reste vorhanden sind.

In dem erfindungsgemäßen Verfahren wird dagegen weder eine salzartige Si-Ge-Verbindung erzeugt, noch sind organische Reste anwesend. Vielmehr wird in dem beanspruchten Verfahren in einem einzigen Schritt ein salzartiger Ausgangsstoff in ein ungeladenes, nicht-ionisches Produkt überführt. Also stellt sich als weiterer, immens wichtiger Vorteil heraus, dass das erfindungsgemäße bzw. das erfindungsgemäß erhaltene Tetrakis(trichlorsilyl)german problemlos in der Halbleiterelektronik eingesetzt werden kann.

Die Erfindung wird im Folgenden näher erläutert.

Der Begriff *"Normaldruck"* ist im Rahmen der Erfindung gleichbedeutend mit dem Begriff *"Umgebungsdruck".* Darunter ist der Druck des umgebenden Gases von 1013 hPa zu verstehen. Der Begriff "Raumtemperatur" wird im Rahmen der Erfindung mit "RT" abgekürzt.

Zumindest ein, zwei, drei oder alle Schritte des erfindungsgemäßen Verfahrens können vorzugsweise unter Normaldruck und/oder in Sauerstoff freier trockener Umgebung durchgeführt werden.

Bei der Umsetzung im Schritt b des erfindungsgemäßen Verfahrens wird ein Rohprodukt erhalten, das neben den Salzen [R₄N][AlCl₄] und/oder [R₄P][AlCl₄] die chlorierte ungeladene Verbindung Tetrakis(trichlorsilyl)german enthält.

Die Ammonium- bzw. Phosphoniumchlorid-Salze bilden mit AlCl₃ Salze des Typs [R₄N][AlCl₄] bzw. [R₄P][AlCl₄], die ebenfalls im Rohprodukt enthalten sind. Von diesen salzartigen Verbindungen wird das ungeladene Molekül der Formel (I) durch Extraktion mit unpolaren Lösungsmitteln abgetrennt und in Reinform gewonnen. Als unpolare Lösungsmittel sind vorteilhafterweise Pentan, Hexan und/oder Benzol geeignet. Besonders bevorzugt kann n-Hexan eingesetzt werden.

Es kann vorteilhaft sein, im Schritt b des erfindungsgemäßen Verfahrens die Umsetzung bei Raumtemperatur durchzuführen, und/oder im Schritt d das unpolare Lösungsmittel bei Raumtemperatur zu entfernen.

Weiterhin kann in dem Schritt b des erfindungsgemäßen Verfahrens als Chlorkohlenwasserstoff Dichlormethan CH₂Cl₂ eingesetzt werden.

In dem Schritt c des erfindungsgemäßen Verfahrens kann vorzugsweise das unpolare Lösungsmittel ausgewählt sein aus Hexan, n-Hexan, Pentan, und/oder Benzol. Besonders bevorzugt kann im Schritt c n-Hexan eingesetzt werden.

Eine weiterhin bevorzugte Ausführungsform des erfindungsgemäßen Verfahrens besteht darin, dass man im Schritt a [X][Ge(SiCl₃)₃] und AlCl₃, wobei diese Komponenten vorzugsweise in festem Zustand sind, mittels Rühren mischt, vorzugsweise in Sauerstoff freier Umgebung, besonders bevorzugt unter Schutzgas, Stickstoff oder Argon, weiterhin bevorzugt in einer Glovebox, und im Schritt b das im Schritt a erhaltene Gemisch vollständig in dem oder den Chlorkohlenwasserstoffen löst, und nach einer Zeit von 0,1 bis 24 Stunden, vorzugsweise nach 1 bis 5 Stunden, den oder die Chlorkohlenwasserstoffe entfernt, vorzugsweise bei einer Temperatur von 5 bis 40 °C, besonders bevorzugt bei Raumtemperatur, weiterhin bevorzugt in Sauerstoff freier trockener Umgebung, besonders bevorzugt in einer isolierten Umgebung, weiterhin bevorzugt unter Normaldruck oder vermindertem Druck, besonders bevorzugt im Bereich von 1 bis 500 hPa.

Es kann des Weiteren vorteilhaft sein, in dem Schritt c des Verfahrens nach dem Einbringen des Rohproduktes die Temperatur des oder der unpolaren Lösungsmittel von 1 mal bis 5 mal, vorzugsweise 3 mal von RT auf erhöhte Temperatur zu bringen. Vorzugsweise kann die Temperatur des oder der unpolaren Lösungsmittel auf den Siedepunkt zumindest eines unpolaren Lösungsmittels gebracht werden, und anschließend kann man das oder die unpolaren Lösungsmittel abkühlen lassen, vorzugsweise auf RT.

Darüber hinaus wurde gefunden, dass Tetrakis(trichlorsilyl)german mit 6 Äquivalenten LiAlH₄ in dem Lösungsmittel Et₂O zu der neutralen hydrierten Verbindung Tetrakis(silyl)german umgesetzt werden kann. Vorzugsweise kann diese Umsetzung in einer Glovebox durchgeführt werden. Weiterhin ist bevorzugt, die Umsetzung bei Raumtemperatur und unter Umgebungsdruck durchzuführen.
Die hydrierte Verbindung Tetrakis(silyl)german ist zwar bereits von Thomas Lobreyer et al. (Angew. Chem. 1993 105, 587-588) beschrieben worden. Dort wurde sie jedoch unter Einsatz der pyrophoren und giftigen Ausgangsstoffe SiH₄ und GeH₄ erhalten.

Das nachfolgende Beispiel erläutert die vorliegende Erfindung zusätzlich, ohne den Gegenstand zu beschränken.

Im Beispiel 1 ist die Umsetzung von [Ph₄P][Ge(SiCl₃)₃] mit AlCl₃ beschrieben. Die Umsetzung anderer Ammonium- bzw. Phosphoniumtris(trichlorosilyl)germanid-Salze des Typs [R₄N][Ge(SiCl₃)₃] bzw. [R₄P][Ge(SiCl₃)₃] lässt sich analog durchführen.

### Analytische Methoden der Kristallstrukturbestimmung

Die Daten für alle Strukturen wurden bei 173 K mit einem STOE IPDS II Zweikreisdiffraktometer mit einer Genix Mikrofokusröhre mit Spiegeloptik unter Verwendung von Mo*K*_{α} Strahlung (*λ* = 0,71073 Å) gesammelt und mit dem frame scaling procedure des Programms *X-AREA* (Stoe & Cie, 2002) skaliert. Die Strukturen wurden mit direkten Methoden mit Hilfe des Programms *SHELXS* (Sheldrick, 2008) gelöst und gegen *F²* mit der full-matrix least-squares Technik verfeinert. Zellparameter wurden durch Verfeinerung gegen θ Werte der Reflexe mit *l*>6σ(*l*) bestimmt.

### Beispiel 1: Herstellung von Tetrakis(trichlorsilyl)german (I).

Die Synthese erfolgte gemäß **Gleichung 1** aus [Ph₄P][Ge(SiCl₃)₃] mit AlCl₃ unter Zugabe von CH₂Cl₂.

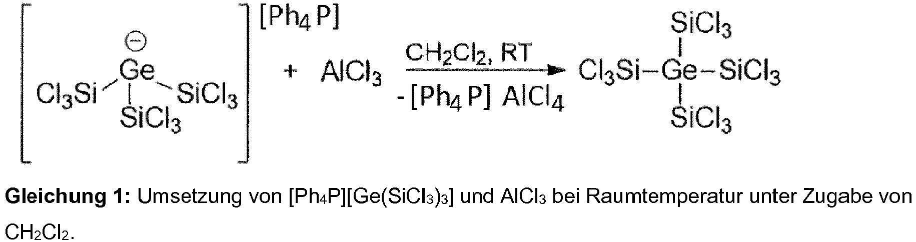

Die Umsetzung wurde in einer Glovebox durchgeführt.

[Ph₄P][Ge(SiCl₃)₃] in einer Menge von 0,10 g, entsprechend 0,12 mmol, und AlCl₃ in einer Menge von 0,016 g, entsprechend 0,12 mmol, wurden in festem Zustand vermischt und anschließend vollständig in Dichlormethan CH₂Cl₂ gelöst.

Nach 3 Stunden wurde das Dichlormethan bei RT und unter Normaldruck langsam verdampft. Nach einem Tag hatte sich ein Gemisch aus Ge(SiCl₃)₄ (I) und [Ph₄P][AlCl₄] als kristallines Rohprodukt gebildet. Das Rohprodukt wurde dreimal mit je 7 ml n-Hexan bis zum Sieden erhitzt. Anschließend wurde die klare, farblose n-Hexan-Lösung mit einer Spritze vom unlöslichen Rückstand abgetrennt.

Das unpolare Lösungsmittel wurde anschließend langsam bei RT und unter Normaldruck entfernt, und nach einem Tag konnte das erfindungsgemäße Produkt Ge(SiCl₃)₄ (***I***) als kristalliner Stoff isoliert werden. Die Ausbeute betrug 0,018 g, entsprechend 0,029 mmol oder 24 %.

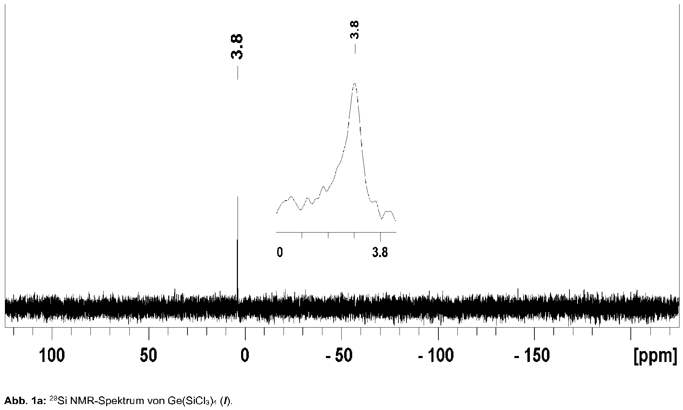

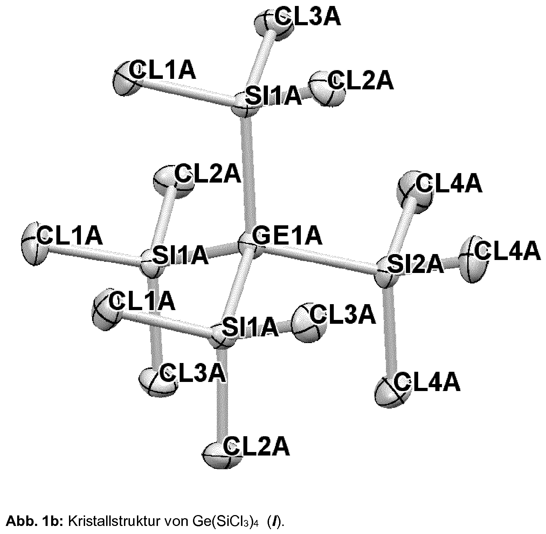

Das ²⁹Si NMR Spektrum des erfindungsgemäßen Produktes **/** ist in **Abb. 1a****,** und das Ergebnis seiner röntgendiffraktometrischen Analyse in **Abb. 1b** dargestellt.

Die Daten der ²⁹Si NMR-spektroskopischen Untersuchung:
**²⁹Si NMR (99,4 MHz, CD₂Cl₂, 298 K):** δ = 3,8 ppm.

## Patentansprüche

1. Verfahren zur Herstellung von Tetrakis(trichlorsilyl)german der Formel (I), 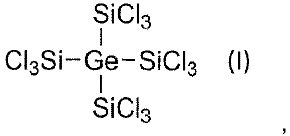 indem man
(a) zumindest ein Tris(trichlorosilyl)germanidsalz des Typs [X][Ge(SiCl₃)₃] mit X = Ammonium (R₄N) und/oder Phosphonium (R₄P),
R = alkylischer oder aromatischer Rest,
mit AlCl₃ mischt, und
(b) in Umgebung zumindest eines Chlorkohlenwasserstoffes bei einer Temperatur von 5 bis 40 °C umsetzt, wobei man ein Rohprodukt erhält, das Salze [R₄N][AlCl₄] und/oder [R₄P][AlCl₄], und Tetrakis(trichlorsilyl)german enthält, und anschließend dieses Rohprodukt
(c) in zumindest ein unpolares Lösungsmittel einbringt und den unlöslichen Rückstand abtrennt, und anschließend
(d) das unpolare Lösungsmittel entfernt, wobei Tetrakis(trichlorsilyl)german erhalten wird.

2. Verfahren nach Anspruch 1, wobei im Schritt b die Umsetzung bei Raumtemperatur durchgeführt wird, und/oder im Schritt d das unpolare Lösungsmittel bei Raumtemperatur entfernt wird.

3. Verfahren nach einem der vorhergehenden Ansprüche, wobei im Schritt b als Chlorkohlenwasserstoff Dichlormethan CH₂Cl₂ eingesetzt wird.

4. Verfahren nach einem der vorhergehenden Ansprüche, **dadurch gekennzeichnet, dass** man im Schritt c das unpolare Lösungsmittel aus Hexan, n-Hexan, Pentan, und/oder Benzol auswählt, vorzugsweise n-Hexan einsetzt.

5. Verfahren nach einem der vorhergehenden Ansprüche, **dadurch gekennzeichnet, dass** man im Schritt a
[X][Ge(SiCl₃)₃] und AlCl₃, wobei diese Komponenten vorzugsweise in festem Zustand sind, mittels Rühren mischt, vorzugsweise
in Sauerstoff freier Umgebung, besonders bevorzugt unter Schutzgas, Stickstoff oder Argon, weiterhin bevorzugt in einer Glovebox,
und im Schritt b
das im Schritt a erhaltene Gemisch vollständig in dem oder den Chlorkohlenwasserstoffen löst, und nach einer Zeit von 0,1 bis 24 Stunden, vorzugsweise nach 1 bis 5 Stunden,
den oder die Chlorkohlenwasserstoffe entfernt, vorzugsweise bei einer Temperatur von 5 bis 40 °C, besonders bevorzugt bei Raumtemperatur, weiterhin bevorzugt in Sauerstoff freier trockener Umgebung, besonders bevorzugt in einer isolierten Umgebung, weiterhin bevorzugt unter Normaldruck oder vermindertem Druck, besonders bevorzugt im Bereich von 1 bis 500 hPa.

6. Verfahren nach einem der vorhergehenden Ansprüche, **dadurch gekennzeichnet, dass** man im Schritt c nach dem Einbringen des Rohproduktes die Temperatur des oder der unpolaren Lösungsmittel von 1 mal bis 5 mal, vorzugsweise 3 mal von RT auf erhöhte Temperatur bringt, vorzugsweise auf den Siedepunkt zumindest eines unpolaren Lösungsmittels, und anschließend das oder die unpolaren Lösungsmittel abkühlen lässt, vorzugsweise auf RT.

## Claims

1. Process for preparing tetrakis(trichlorosilyl)germane of the formula (I), 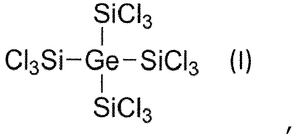 by
(a) mixing at least one tris(trichlorosilyl)germanide salt of the [X][Ge(SiCl₃)₃] type where X = ammonium (R₄N) and/or phosphonium (R₄P),
R = alkylic or aromatic radical,
with AlCl₃, and
(b) reacting same in an environment consisting at least of one chlorinated hydrocarbon at a temperature of 5 to 40°C to obtain a crude product comprising salts [R₄N][AlCl₄] and/or [R₄P][AlCl₄] and tetrakis(trichlorosilyl)germane, and subsequently
(c) introducing said crude product into at least one nonpolar solvent and separating off the insoluble residue, and subsequently
(d) removing the nonpolar solvent, to obtain tetrakis(trichlorosilyl)germane.

2. Process according to Claim 1, wherein in step b the reaction is conducted at room temperature, and/or in step d the nonpolar solvent is removed at room temperature.

3. Process according to either of the preceding claims, wherein, in step b, the chlorinated hydrocarbon used is dichloromethane CH₂Cl₂.

4. Process according to any of the preceding claims, **characterized in that**, in step c, the nonpolar solvent is selected from hexane, n-hexane, pentane and/or benzene; n-hexane is preferably used.

5. Process according to any of the preceding claims, **characterized in that**, in step a,
[X] [Ge (SiCl₃)₃] and AlCl₃, these components preferably being in the solid state, are mixed by means of stirring, preferably in an oxygen-free environment, particularly preferably under protective gas, nitrogen or argon, additionally preferably in a glovebox, and, in step b,
the mixture obtained in step a is dissolved completely in the chlorinated hydrocarbon(s), and, after a time of 0.1 to 24 hours, preferably after 1 to 5 hours,
the chlorinated hydrocarbon(s) are removed, preferably at a temperature of 5 to 40°C, particularly preferably at room temperature, additionally preferably in an oxygen-free, dry environment, particularly preferably in an isolated environment, additionally preferably under standard pressure or reduced pressure, particularly preferably in the range from 1 to 500 hPa.

6. Process according to any of the preceding claims, **characterized in that**,
in step c, after the introduction of the crude product, the temperature of the nonpolar solvent(s) is brought for from 1 to 5 times, preferably 3 times, from RT to elevated temperature, preferably to the boiling point at least of one nonpolar solvent, and subsequently the nonpolar solvent(s) are allowed to cool, preferably to RT.

## Revendications

1. Procédé pour la préparation de tétrakis(trichlorosilyl)germane de formule (I), 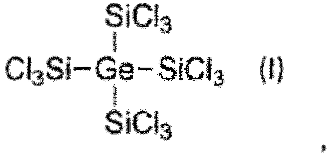
(a) en mélangeant au moins un sel de tris(trichlorosilyl)germanide du type [X] [Ge (SiCl₃)₃] avec
X = ammonium (R₄N) et/ou phosphonium (R₄P),
R = radical alkylique ou aromatique,
avec AlCl₃, et
(b) en le transformant en présence d'au moins un hydrocarbure chloré à une température de 5 à 40 °C, dans lequel on obtient un produit brut, qui contient des sels de [R₄N][AlCl₄] et/ou [R₄P][AlCl₄], et le tétrakis(trichlorosilyl)germane, et ensuite
(c) en introduisant ce produit brut dans au moins un solvant apolaire et en séparant le résidu insoluble, et ensuite
(d) en éliminant le solvant apolaire, le tétrakis(trichlorosilyl)germane étant obtenu.

2. Procédé selon la revendication 1, la transformation dans l'étape b étant mise en œuvre à la température ambiante et/ou dans l'étape d le solvant apolaire étant éliminé à température ambiante.

3. Procédé selon l'une quelconque des revendications précédentes, le dichlorométhane CH₂Cl₂ étant utilisé comme hydrocarbure chloré dans l'étape b.

4. Procédé selon l'une quelconque des revendications précédentes, **caractérisé en ce qu'**on choisit, dans l'étape c, le solvant apolaire parmi un hexane, le n-hexane, le pentane, et/ou le benzène, de préférence on utilise le n-hexane.

5. Procédé selon l'une quelconque des revendications précédentes, **caractérisé en ce que**, dans l'étape a,
on mélange [X] [Ge (SiCl₃)₃] et AlCl₃ sous agitation, ces composants étant de préférence à l'état solide, de préférence
dans un environnement exempt d'oxygène, particulièrement préférablement sous un gaz protecteur, de l'azote ou de l'argon, en outre préférablement dans une boîte à gants,
et dans l'étape b
on dissout totalement le mélange obtenu dans l'étape a dans l'hydrocarbure ou les hydrocarbures chloré(s), et après un temps de 0,1 à 24 heures, de préférence après 1 à 5 heures,
on élimine le ou les hydrocarbure(s) chloré(s), de préférence à une température de 5 à 40 °C, particulièrement préférablement à température ambiante, en outre préférablement dans un environnement sec exempt d'oxygène, particulièrement préférablement dans un environnement isolé, en outre préférablement sous pression normale ou sous pression réduite, particulièrement préférablement dans la plage de 1 à 500 hPa.

6. Procédé selon l'une quelconque des revendications précédentes, **caractérisé en ce qu'**on amène, dans l'étape c après l'introduction du produit brut, la température du ou des solvant(s) apolaire(s), 1 fois à 5 fois, de préférence 3 fois, de la température ambiante à une température élevée, de préférence au point d'ébullition d'au moins un solvant apolaire, et ensuite on laisse refroidir le ou les solvant(s) apolaire(s), de préférence à température ambiante.
